# EUROPEAN PATENT SPECIFICATION

(11) **EP 1 931 185 B1**
(45) Date of publication and mention of the grant of the patent: **10.02.2010**
(21) Application number: 06025340.8
(22) Date of filing: 07.12.2006
(51) Int. Cl.: H05K 1/16, G11B 7/09, H01F 27/28

(54) **Printed circuit board for an optical pickup with interleaved tilt and focus windings printed thereon**
Leiterplatte für einen optischen Lesekopf mit verschränkter Neigung und darauf angebrachte Fokuswindungen
Carte de circuit imprimé pour une capture optique avec inclinaison intercalée et enroulements de focalisation imprimés sur celle-ci

(43) Date of publication of application: 11.06.2008
(73) Proprietor: Harman Becker Automotive Systems GmbH, 76307 Karlsbad (DE)
(72) Inventor: Suzuki, Tsuneo, 78087 Mönchweiler (DE); Dupper, Rolf, 78050 VS-Villingen (DE)
(74) Representative: Grünecker, Kinkeldey, Stockmair & Schwanhäusser Anwaltssozietät

(56) References cited:
- EP-A- 1 339 051
- EP-A- 1 646 122
- JP-A- 6 243 492
- JP-A- 8 203 104
- US-A- 2 474 988

## Description

### Field of the Invention

The present invention relates to a printed circuit board having printed coils thereon, and to a method of manufacturing same. Such a printed circuit board can be implemented particularly in an actuator for an optical pickup in an optical recording and/or reproducing apparatus. An application in hard drives or electrical adjustment drives can also be considered.

### Background of the Invention

Generally, an optical pickup is used for an optical recording and/or reproducing apparatus. The optical pickup moves over an optical information storage medium, such as an optical disk, in a radial direction of the optical disk and records/reproduces information onto/from the optical disk in a non-contacting way.

The optical pickup needs an optical pickup actuator driving an objective lens in a tracking direction and a focus direction, and optionally, in a tilt direction, to make light emitted from a light source, usually a laser source, form a light spot at a correct position on the optical disk.

As the storage capacity of the optical disk increases, a numerical aperture of the objective lens increases, which causes an aberration, when the optical disk is tilted with respect to the objective lens. A reproducing capability of the optical pickup actuator decreases due to the increasing numerical aperture, and the increase of the numerical aperture causes writing signals of the optical disk to deteriorate due to the deformation of a pit, formed on the optical disk in an information writing operation.

In order to overcome the above problem, a tilt error, as well as a focusing and tracking error, have to be compensated. Thus, the optical pickup actuator is moved in the tilt direction in addition to the tracking and focus directions.

In conventional optical pickups, the magnetic circuits on the surface of the printed circuit boards (PCB) are typically realized using wound coils. However, in more recent systems, the magnetic circuits have been imprinted on the printed circuit board. This has allowed to reduce the volume of the actuator as well as its weight by suppressing the need for bulky coil windings. Still, a printed circuit board in an optical pickup actuator typically comprises a plurality of layers of magnetic circuits, wherein the PCB remains quite voluminous and difficult to produce.

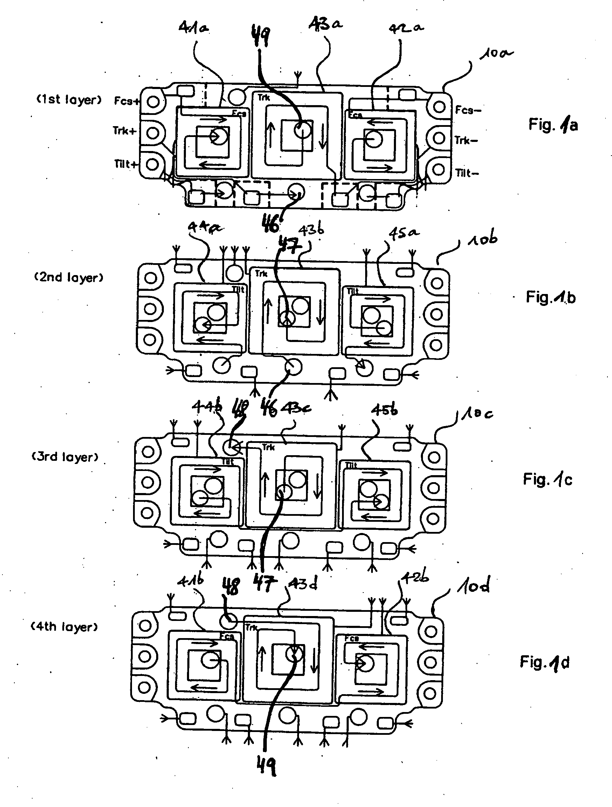

An example will be illustrated with respect to Figs. 1a, 1b, 1c and 1d, which show a multi-layered arrangement of magnetic circuits having coil windings printed on a surface thereof, the layers of magnetic circuits being separated by insulating layers from each other, for instance by epoxy layers.

Fig. 1a represents a first layer 10a, wherein three magnetic circuits 41a, 42a, 43a are represented, each of which comprises coil windings that are wound around an axis that is essentially perpendicular to a plane of the first layer 10a. In addition, in Fig. 1 a the first magnetic circuit 41 a and the second magnetic circuit 42a are arranged on both ends, left and right, of the first layer 10a, and are intended as focus coil windings. The third magnetic circuit 43a, arranged between the first and second magnetic circuit 41 a, 42a, is a tracking coil winding. The first, second and third magnetic circuit 41 a, 42a, 43a are each connected to terminals Fcs+/Fcs-, Trk+/Trk-, Tilt+/Tilt-, on which input signals may be applied.

Fig. 1b shows a second layer 10b of the multi-layered arrangement of the printed circuit board, wherein a fourth and fifth magnetic circuit 44a, 45a are arranged on both outer sides of the second layer 10b. A sixth magnetic circuit 43b is arranged between the fourth and fifth magnetic circuits 44a, 45a. The fourth and fifth magnetic circuits 44a, 45a are tilt coil windings, whereas the sixth magnetic circuit 43b is a tracking coil winding. As apparent from Figs. 1a and 1b, through-holes, e.g. 46 and 47, are arranged on the first and second layers 10a, 10b to allow for a signal, input at one of the terminals and going through a coil winding of the first layer 10a, to be transmitted to the corresponding coil winding of the second layer 10b.

Fig. 1c shows a third layer 10c comprising a seventh and eighth magnetic circuit 44b and 45b that are tilt coil windings. The third layer 10c further comprises a ninth magnetic circuit 43c that is a tracking coil winding. Fig. 1d shows a fourth layer 10d of the multi-layered arrangement, comprising a tenth and eleventh magnetic circuit 41 b, 42b that are focus coil windings, and a twelfth magnetic circuit 43d that is a tracking coil winding.

For better understanding the connections between the different layers of the PCB, the course of the tracking circuit will be briefly illustrated. Current is input via the terminal Trk+ into the through-hole 46 of the first layer 10a. The current passes via said connection through the first layer to the second layer and into the coil 43b. Then, the through-connection 47 is used for passing the current to the third layer 10c and to coil 43c. Similarly, through-hole 48 is used to guide the current to the fourth layer 10d and into the coil 43d. Finally, the current flows via through-hole 49 back to the first layer 10a, into the coil 43a and then to the right terminal Trk-.

A similar configuration applies to the remaining focus and tilt-functions.

However, such a multi-layered arrangement of magnetic circuits, in order to enable the focusing, tracking and tilting functions, has a complicated structure. Furthermore, due to the four layers, the PCB is also relatively large.

A non-conductive actor substrate in accordance with the preamble of claim 1 is disclosed in EP 1 339 051 A2.

### Summary of the Invention

In light of the above mentioned problems, the object of the invention is to provide a printed circuit board with printed coils thereon, that is easier to manufacture and smaller in size.

The object is solved by the subject matter of the independent claims. Advantageous embodiments of the invention are subject-matters of the dependent claims.

One aspect of the invention is to reduce the necessary layers of the PCB by interleaving the printed coils thereon in order to reduce space of the coils.

According to the invention a non-conductive actor substrate with at least two spiral coils arranged thereon is suggested. The at least two spiral coils generate a first magnetic field which interacts with a second magnetic field for moving a mobile component. A first spiral coil and a second spiral coil of conductive material are fixed on a first surface of the non-conductive actor substrate and are interleaved with each other. Furthermore, the first spiral coil and the second spiral coil are arranged around a first point on the first surface in such a way that, when a first and second current signal are introduced respectively into the first and second spiral coils, the mobile component moves in a direction substantially coplanar to the first surface of the non-conductive actor substrate.

According to an embodiment of the invention, the first and second spiral coils have substantially the same length, which facilitates the application of said coils.

According to an alternative to the previous embodiment of the invention, the first and second spiral coils have a different length. This is advantageous in cases where the necessary strengths of the respective magnetic fields differ, thereby allowing to reduce the space on the PCB that is used for said coils.

Furthermore, in a different embodiment of the invention the mobile component is attached to the non-conductive actor substrate. The non-conductive actor substrate moves in a direction substantially coplanar to the first surface of the non-conductive actor substrate, when the first and second current signal are introduced respectively into the first and second spiral coils. Thus, the position of the mobile component may be easily controlled by moving the non-conductive actor substrate.

Another aspect of the invention relates to the first current signal being input via a first terminal, arranged on one edge of the first surface of the non-conductive actor substrate and connected to the first spiral coil. The first current signal flows from the first terminal via the first spiral coil to a second terminal, arranged on the other edge of the first surface of the non-conductive actor substrate. The second current signal is input via a third terminal, arranged on the one edge of the first surface of the non-conductive actor substrate and connected to the second spiral coil. Additionally, the second current signal flows from the third terminal via the second spiral coil to a fourth terminal, arranged on the other edge of the first surface of the non-conductive actor substrate. Necessary connections to the terminals may be implemented without disturbing each other, because of the provision of the terminals on the opposing sides of the PCB.

In a further embodiment of the invention a third spiral coil and a fourth spiral coil of conductive material are fixed on a second surface of the non-conductive actor substrate. The second surface is the side opposite the first surface and the third and fourth spiral coils are arranged around the first point. In addition, the third and fourth spiral coils are interleaved with each other, while the third spiral coil is connected to the first spiral coil via a first connection through the non-conductive actor substrate. The fourth spiral coil is connected to the second spiral coil via a second connection through the non-conductive actor substrate. As the second surface is used for providing additional coils, the force generated by the coils is increased, while allowing an easy implementation on opposing surfaces of the PCB.

According to a different aspect of the invention, a fifth spiral coil and a sixth spiral coil are fixed on the first surface of the non-conductive actor substrate. The fifth spiral coil and the sixth spiral coil are arranged around a second point on the first surface and are interleaved with each other. Specifically, the first point and second point are spaced at least a minimum distance from each other such that the first and second spiral coils do not overlap the fifth and sixth spiral coils.

Moreover, in an advantageous embodiment of the invention, a seventh spiral coil and an eighth spiral coil are fixed on the second surface of the non-conductive actor substrate. The seventh spiral coil and the eighth spiral coil are arranged around the second point and are interleaved with each other. The seventh spiral coil is connected to the fifth spiral coil via a third connection through the non-conductive actor substrate, and the eighth spiral coil is connected to the sixth spiral coil via a fourth connection through the non-conductive actor substrate.

According to a still different embodiment of the invention, the eighth spiral coil is connected to the fourth terminal via a fifth connection through the non-conductive actor substrate.

An additional aspect of the invention suggests that the third spiral coil is connected to the seventh spiral coil via a first pathway of conductive material arranged on the second surface of the non-conductive actor substrate. Further, the fourth spiral coil is connected to the sixth spiral coil via a second pathway of conductive material arranged on the first or second surface of the non-conductive actor substrate and via a sixth connection through the non-conductive actor substrate. The interconnection between the different coils allows e.g. for an easy appliance of the input signals, as the inputted signal also flows into the sixth spiral coil.

According to another embodiment of the invention, a first axis passes through the first point and the second point. A third point lies on the first axis between the first and second point and a second axis passes through the third point and is perpendicular to the first axis and within the plane of the first surface. When the first current signal flows through the first, third, seventh and fifth spiral coils, the mobile component moves in a focus direction, which is substantially coplanar to the first surface and in a direction substantially parallel to the second axis.

In a different embodiment of the invention when the second current signal flows through the second, fourth, sixth and eighth spiral coils, the mobile component rotates in a tilt rotational direction, which is around a third axis, that is substantially perpendicular to the first and second axis.

A different aspect of the invention suggest to include a ninth spiral coil (619) fixed on the first surface and arranged around the third point, in such a way that when a third current signal is introduced into the ninth spiral coil, the mobile component moves in a tracking direction. The tracking direction is substantially within the plane of the first surface and in a direction substantially parallel to the first axis. The third point is spaced at least a minimum distance from the first point and the second point such that the ninth coil does not overlap the first, second, fifth and sixth coil. A tracking error may thereby be corrected.

According to an advantageous embodiment of the invention, the third current signal is input via a fifth terminal (635), arranged on the one edge of the first surface of the non-conductive actor substrate and connected to the ninth spiral coil. The third current signal flows from the fifth terminal via the ninth spiral coil to a sixth terminal (636), arranged on the other edge of the first surface of the non-conductive actor substrate.

Another embodiment of the invention suggest to provide a tenth spiral coil (620) fixed on the second surface and arranged around the third point. Further, the tenth spiral coil is connected to the ninth spiral coil via a seventh connection (627) through the non-conductive actor substrate.

According to a still advantageous embodiment of the invention, the tenth spiral coil is connected to the sixth terminal via a third pathway on the first or second surface of the non-conductive actor substrate and via an eighth connection (628) through the non-conductive actor substrate.

According to the invention, a method for manufacturing a non-conductive actor substrate with at least two spiral coils arranged thereon is suggested. The at least two spiral coils generate a first magnetic field, which interacts with a second magnetic field for moving a mobile component. At first, a first spiral coil of conductive material is fixed on a first surface of the non-conductive actor substrate, wherein the first spiral coil is arranged around a first point on the first surface. In addition, a second spiral coil of conductive material is fixed on the first surface of the non-conductive actor substrate, wherein the second spiral coil is arranged around the first point and is interleaved with the first spiral coil. Further, the fixing the spiral coils is such that when a first and second current signal are introduced respectively into the first and second spiral coil, the mobile component moves in a direction substantially coplanar to the first surface.

### Brief Description of the Figures

- **Fig. 1a**: is an overview of a first layer of a multi-layered arrangement of magnetic circuits of a printed circuit board of the prior art;
- **Fig. 1b**: is an overview of a second layer of a multi-layered arrangement of magnetic circuits of a printed circuit board of the prior art;
- **Fig. 1c**: is an overview of a third layer of a multi-layered arrangement of magnetic circuits of a printed circuit board of the prior art;
- **Fig. 1d**: is an overview of a fourth layer of a multi-layered arrangement of magnetic circuits of a printed circuit board of the prior art;
- **Fig. 2**: is a perspective view of an optical pickup actuator;
- **Fig. 3**: is a perspective view of a portion of the optical pickup actuator shown in Fig. 2;
- **Fig. 4**: is a perspective view of a printed circuit board arranged between two eight-pole magnets in the optical pickup actuator shown in Fig. 2;
- **Fig. 5**: is a schematic view of a portion of a printed circuit board with a coil printed thereon;
- **Fig. 6a**: shows an overview of a first side of a printed circuit board according to one embodiment of the invention;
- **Fig. 6b**: shows an overview of a second side of the printed circuit board according to the embodiment of the invention;
- **Fig. 7a**: shows an overview of the first side of the printed circuit board, further illustrating the current flow directions in the coils printed thereon;
- **Fig. 7b**: shows an overview of the second side of the printed circuit board, further illustrating the current flow directions in the coils printed thereon; and
- **Fig. 8**: is an overview of the first side of the printed circuit board, further illustrating the constant magnetic fields present.

### Detailed Description

Reference will now be made in detail to the embodiments of the invention, examples of which are illustrated in the accompanying drawings, wherein like reference numerals refer to the like elements. The embodiments are described below in order to explain the invention by referring to the figures.

An optical pickup actuator comprises a lens holder movably installed at a base, a suspension supporting the lens holder to move with respect to the base, and a magnetic circuit installed to face the lens holder and the base. Such optical pickup actuator moves at least in a tracking direction, that is radial across the optical disk, and a focus direction, that is perpendicular to the surface of the optical disk.

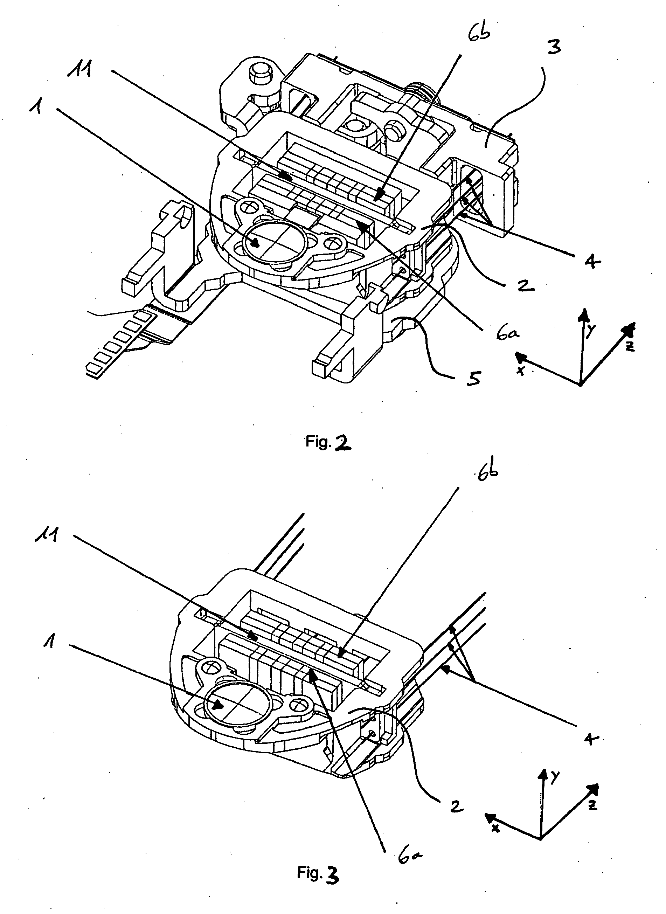

Fig. 2 shows a perspective view of an optical pickup actuator. The optical pickup comprises an objective lens 1 that is mounted on a lens holder 2. It further comprises a support member 4, an end of which is fixed at a side of the lens holder 2 and the other end of which is fixed at a holder 3 that is provided on a base 5. The lens holder 2 is movable with respect to the base 5.

A printed circuit board 11, of non-conductive material, having magnetic circuits arranged thereon is fixed to the lens holder 2, and is arranged between two magnets 6a and 6b which are fixed on the base 5. The magnetic field generated by the magnetic circuits of the PCB 11 interacts with the constant magnetic field of the magnets 6a, 6b, so as to move the objective lens 1. Accordingly, the printed circuit board 11 is movable along the y-direction (focusing direction), x-direction (tracking direction), or in a tilt rotational direction within the plane x-y. According to this embodiment, the printed circuit board 11 functions as the actuator, because the lens holder 2 (and the objective lens) is attached to the PCB 11 and moves along with same. However, it might also be possible to make the magnets 6a, 6b movable in relation to the base and attach the lens holder (and the objective lens) to the movable magnets (not shown). Accordingly, the objective lens would be moved along with the magnets. Nevertheless, for the remaining illustrations the PCB 11 is movable, and the objective lens is joined with the PCB so as to move together with same.

Fig. 3 shows a perspective view of the lens holder 2 and printed circuit board 11 mounted between the magnets 6a, 6b as shown in Fig. 2, but with the holder 3 and base 5 being omitted.

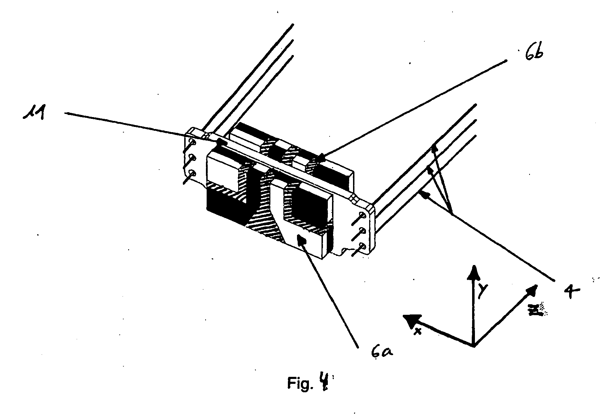

Fig. 4 shows a perspective view of the printed circuit board 11 arranged between the two magnets 6a and 6b. The magnets 6a and 6b are 8-pole magnets, wherein the portions represented in black correspond to the north pole and the portions represented in white to the south pole (or vice versa). The neutral portions are hatched. The first magnet 6a and second magnet 6b are arranged such that a pole of the first magnet, be it the north or south pole, faces the opposite pole of the second magnet 6b.

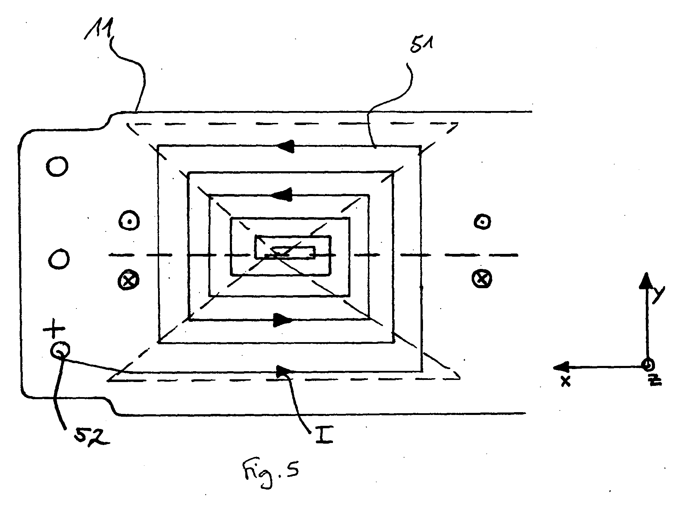

Fig. 5 shows a schematic representation of a portion of one layer of a printed circuit board 11, in particular one coil winding 51. The framed areas (two triangles limited by dashed lines) in Fig. 5 show the magnetically active domains in the coil winding 51. Active domains of the coil winding 51 have current flowing through them in an orientation such that, when placed in the magnetic field produced by the magnets 6a and 6b shown in Fig. 4, they contribute to the creation of an electromagnetic force to move the printed circuit board.

In particular, current I is input via a terminal 52 into the coil winding 51. The direction of the current is counter-clockwise and thus in the lower part of the winding 51 in negative x-direction and in the upper portion of the coil winding 51 in positive x-direction, as illustrated in Fig. 5 via the arrowheads. Furthermore, the 8-pole magnets shown in Fig. 4 create a magnetic field that is perpendicular to the surface of the printed circuit board. Under the assumption that the lines of magnetic flux go from north to south, the upper half of the coil winding 51 in Fig. 5 is within a magnetic field directed from the front side to the back side of the illustrated surface. Accordingly, in the lower half the magnetic flux is directed from the back side to the front side. The direction of the electromagnetic force that is created by the flowing current in the constant magnetic field may be determined by using Fleming's right hand rule. Consequently, the force resulting from the current in both active domains is directed in the negative Y-direction.

The other domains, that is the domains outside the framed area, do not contribute to the creation of such an electromagnetic force. The current in the inactive domains flows in the Y-direction or negative Y-direction. Due to the arrangement of the magnets and the resulting magnetic flux, the forces generated by the inactive domains cancel each other out.

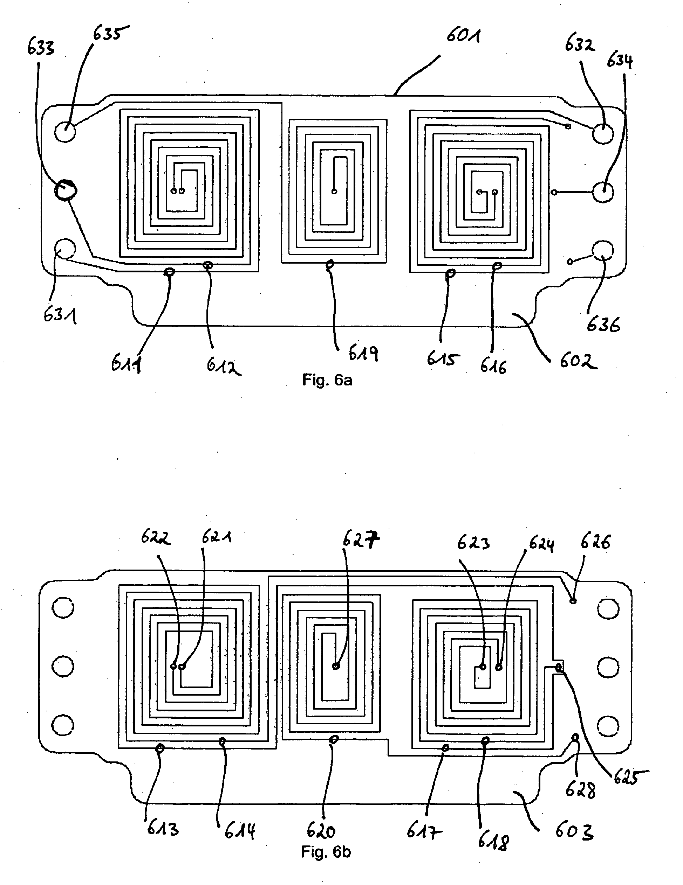

In Fig. 6a a first surface 602 of a printed circuit board 601 according to one embodiment of the invention is illustrated. A second surface 603 of the PCB 601 is illustrated in Fig. 6b, the second surface being the side opposite the first surface.

The first surface 602 has a first pattern of conductive material printed thereon, comprising a first spiral coil 611, a second spiral coil 612, a ninth spiral coil 619, a fifth spiral coil 615 and a sixth spiral coil 616. Each spiral coil of the first surface is wound clockwise around a center point, when looking from the inside to the outside. Furthermore, the first and second spiral coils 611, 612 are interleaved with each other, so as to form a very compact and space-saving circuit. That is, the coils 611, 612 are closely wound around a same centered point and alternate each other. Similarly, the fifth 615 and sixth spiral coil 616 also are alternatively wound around a common center point, such that both coils interleave each other. Moreover, the first pattern of coils on the first surface is arranged in such a way that the coils 611, 612, 619, 615, 616 do not overlap each other. Therefore, the center points around which each coil is respectively wound are sufficiently spaced from one another, so that no coil winding touches another coil winding, thereby inhibiting cross-currents.

The second surface 603, shown in Fig. 6b, has a second pattern of conductive material printed thereon, comprising a third spiral coil 613, a fourth spiral coil 614, a tenth spiral coil 620, a seventh spiral coil 617 and an eighth spiral coil 618. The winding direction of the coils around respective center points on the second surface 603 is counterclockwise, when going from the inside to the outside, thus the opposite than the direction of winding in the coils of the first surface 602. Similar to the first surface, the third and fourth spiral coils 613, 614 are interspersed with each other, that is they are wound in such a way that the respective winding of the third coil is between the respective winding of the fourth coil, and vice versa. Same applies to the seventh 617 and eighth coils 618.

In a further embodiment of the invention, the various spiral coils may have different lengths of windings. The strength of the generated electromagnetic force lessens with the length of the winding of a spiral coil, while maintaining the general direction of force. For instance, if the tilt function does not need as much force as the focus function, it is possible to reduce the length of winding of the tilt coils, thereby saving cost in manufacturing.

The various spiral coils of the PCB 601 are interconnected with each other in such a way that they form three separate circuits, provided for different functions of the optical pickup system.

In order to move the printed circuit board 601 in a focus direction, which is in positive and negative Y-direction, four spiral coils 611, 613, 617, 615 are provided on the PCB 601. The focus-function is controlled via a current I₁. More specifically, the first spiral coil 611 is connected to the third spiral coil via a through-hole 621 which goes through the conductive medium from one surface 602 to the other surface 603. The third spiral coil 613 in turn is connected to the seventh spiral coil 617 on the second surface 603 via a pathway of conductive material arranged on the second surface. The seventh spiral coil 617 is further connected with the fifth spiral coil 615 on the first surface via a connection 623 through the PCB from the second surface to the first surface. Said interconnected four spiral coils 611, 613, 617, 615 form a focus circuit that extends on the two surfaces. The corresponding current I₁ is input via a terminal 631 on the left side of the first surface 602 of the PCB. Consequently, the current I₁ flows through the first, third, seventh and fifth spiral coils before flowing into a further terminal 632, located at the right side of the first surface.

Similarly, a tilt function, which rotates the PCB 601 within the x-y-plane, is provided by the second 612, fourth 614, sixth 616 and eighth spiral coils 618. In particular, the second spiral coil 612 on the first surface is connected to the fourth spiral coil 614 on the second surface via a through connection 622, which trespasses the PCB from one surface to the other. The fourth spiral coil 614 connects to the sixth spiral coil 616 of the first surface via a pathway of conductive material and via a through connection 626. The pathway may be either on the first and/or second surface, depending on where the through connection 626 is located. In the embodiment of the invention illustrated in Fig. 6a and 6b the pathway is provided on the second surface, as the through connection is positioned far on the left, right next to the beginning of the sixth spiral coil 616. Then, the sixth spiral coil 616 is linked with the eighth spiral coil 618 on the second surface again via a through connection 624.

The tilt circuit is supplied with a tilt current I₂ via a terminal 633 on the left side of the first surface. Accordingly, the current I₂ flows through the second, fourth, sixth and eighth spiral coil 612, 614, 616, 618. In order to flow into another terminal 634 provided on the right side of the first surface, a through connection 625 is used to direct the current from the second surface to the first surface and into the terminal 634.

The tracking function, needed for an optical backup to move across the surface of the readable disk in a positive or negative x-direction, is provided by the ninth 619 and tenth spiral coil 620. The ninth spiral coil 619 of the first surface is connected via a connection 627 through the non-conductive medium PCB to the tenth spiral coil 620 on the second surface 603. A further terminal 635 on the left side of the first surface is used for applying a current I₃ to the coil 619 of the tracking circuit. The current I₃ then flows through the connection 627 into the tenth coil 620 on the second surface. As the current has to be output via a terminal 636 on the right side of the first surface, a pathway of conductive material and a through connection 628 are provided to connect the tenth spiral coil 620 from the second surface to the first surface and to the terminal 636. Again, the pathway may be arranged on the first and/or second surface, depending on the positioning of the through connection 628.

As a result of the arrangement and interconnection of the various spiral coils, it is possible to move the printed circuit board selectively in the y and x-direction, and cause the PCB to be rotated within the y-x-plane. The focus circuit, comprising the spiral coils 611, 613, 617, 615 with respectively two spiral coils fixed on each surface of the PCB, has a direction of current in the different domains with opposing magnetic flux, that consistently creates a magnetic force in either the positive **or** negative y-direction.

Similarly, the tracking circuit, composed of coils 619, 620, consistently creates an electromagnetic force in either the positive **or** negative x-direction.

On the other hand, in order to create a rotational force, the tilt-function creates opposing electromagnetic forces in the y-direction on the left and right side of the PCB. That is, independent from the inputted current, the spiral coils 612 and 614 on the left side create a force in the y-direction that is opposite the force created by the coils 616, 618 on the right side of the PCB. Thus, the PCB is caused to rotate within the x-y-plane, namely around an axis that is perpendicular to the first/second surface and goes through a point on the PCB which is substantially centered between the center point of the first, second, third, fourth coils and between the center point of the fifth, sixth, seventh, eighth spiral coil.

Thus, depending on the direction of the inputted currents I₁, I₂, I₃ any of the above described moving directions are possible.

The creation of the different forces will be explained in detail in the following paragraphs.

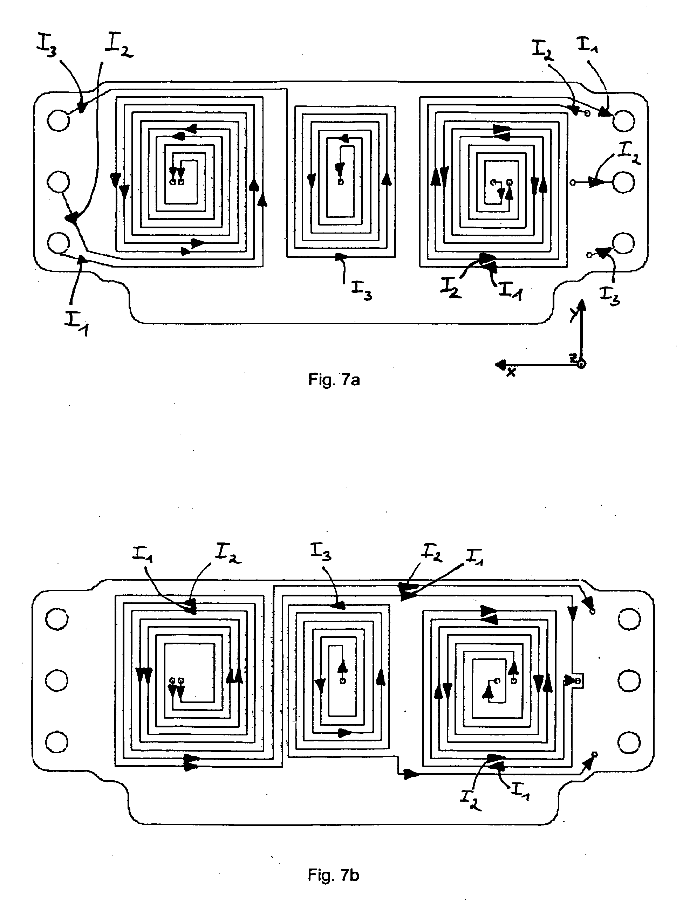

Assuming that the applied currents generally flow from the left terminals 631, 633, 635 to the right terminal 632, 634, 635, respectively, the current within each spiral coil is directed as illustrated in Fig. 7a and 7b, whereas Fig. 7a shows the first surface 602 of the printed circuit board 601, and Fig. 7b presents the second surface 603 of the PCB 601.

In particular, the direction of the current I₁ in the first spiral coil 611 is counterclockwise, likewise the direction of the current I₂ in the second spiral coil 612 of the first surface. As further apparent from Fig. 7a, the direction of current I₃ in the ninth spiral coil 619 is also counterclockwise.

Due to specific interconnection of the various coils on the first surface and the coils on the second surface, and due to the specific arrangement of the different coils, the direction of the currents in the coils of the second surface is predefined by the direction of the current in the coils of the first surface, and vice versa in the case of the fifth and sixth coils 615, 616 on the first surface.

For instance, the third spiral coil 613 and the fourth spiral coil 614, which are respectively connected to the first and second spiral coils, show a direction of current that is counterclockwise, as shown in Fig. 7b. This partly stems from the specific positioning of the through holes 621, 622, which are situated substantially in the middle of the spiral coils 613, 614 (and also of coils 611, 612). Furthermore, the spiral coils 613, 614 are wound counterclockwise from the inside to the outside. Consequently, the currents I₁ and I₂ flow from the inside of the coils 613, 614 to the outside of the coils and thus in a counterclockwise direction.

In accordance therewith, the direction of the current I₃ flowing in the tenth spiral coil 620 is also counterclockwise, as the transition from one side of the PCB to the other takes place in the center of the two coils 619, 620. Consequently, the current I₃ flows from the inner part of coil 620 to the outer part of same.

As already mentioned, the third spiral coil 613 is connected to the seventh spiral coil 617, both being arranged on the second surface, via a pathway, illustrated in the upper part of the second surface 603 of the PCB 601. As clearly apparent from Fig. 6b or 7b, this interconnection occurs on the outside of the seventh coil 617. Thus, the current I₁, flows from the outside to the center of the seventh coil 617 in a clockwise direction.

The same applies to the sixth coil 616 on the first surface 602. In particular, the fourth spiral coil 614 is connected to the sixth spiral coil via a pathway across the second surface and via a through hole 626. From Fig. 7b it is easily discernable that the through connection happens on the outside of the sixth coil. This time however the direction of the current I₂ is counterclockwise as the winding of the sixth coil is clockwise, the winding direction being defined from the inside to the outside.

On the other hand, the current I₁ flowing through the fifth spiral coil 615 on the first surface is clockwise, because the current flows from the seventh spiral coil via the through connection 623 into the fifth spiral coil 615, wherein the connection 623 is in the center of the fifth coil. Thus, the current I₁ flows from the inside to the outside in a clockwise direction.

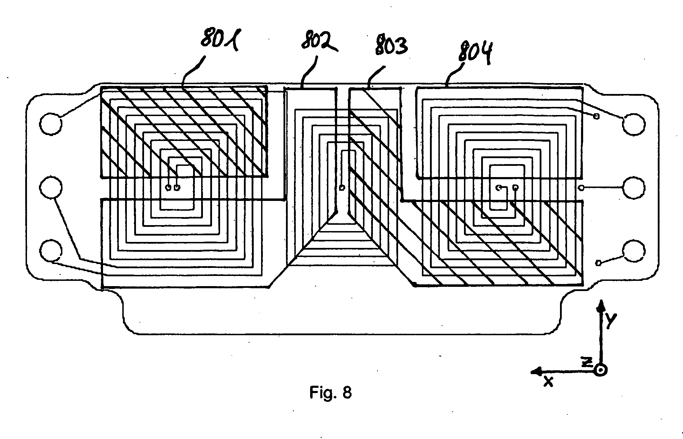

Fig. 8 shows an overview of the first surface 602 of the PCB 601, wherein the constant magnetic field areas are illustrated. It is assumed that the 8-pole magnets 6a and 6b are used, that have been described with reference to Fig. 4. In accordance therewith, the areas 801-804 in which a constant magnetic flux exists have been drawn over the illustration of the first surface of the printed circuit board. Hatched areas denote one direction of magnetic flux and non-hatched areas denote the opposite direction of magnetic flux, be it in positive or in negative z-direction. It goes without saying that the magnetic flux, illustrated in Fig. 8, also trespasses the second surface 603 of the printed circuit board 601 in the same way as the first surface 602.

In order to determine which coil areas cause which electromagnetic force, it is necessary to combine the constant magnetic field direction with the different directions of current in the various coils of both surfaces.

In order to better illustrate the embodiment of the invention, it is assumed that the hatched areas have a general direction of magnetic flux in the positive z-direction, thus from the front side of the PCB to the back side. Accordingly, non-hatched areas are located within a magnetic flux directed in the negative z-direction, from the back side to the front side.

As a result, the upper area of the first, second, third and fourth spiral coils 611, 612, 613, 614 and their currents I₁, I₂ ,flowing in the positive x-direction, are located within the magnetic area 801. The resulting electromagnetic forces are thus directed in negative y-direction. The currents that are trespassed by the magnetic flux of area 802, though they have an opposite direction than the currents in the area 801, namely the negative x-direction, generate an electromagnetic force in the same negative y-direction, because also the magnetic flux is opposite. Currents flowing in the positive and negative direction within the coils 611-614 generally cancel each other out, and therefore do not generate a substantial electromagnetic force.

Moreover, the magnetic flux of area 802 also causes an electromagnetic force through the current I₃ of the ninth and tenth spiral coil 619, 620. The direction of the current is in the negative y-direction, as can be seen in Fig. 7a and 7b. Thus, the generated electromagnetic force that affects the PCB is directed in the positive x-direction. This force coincides with the electromagnetic force generated by the current I₃ flowing in the positive y-direction and being within the magnetic field of area 803. Again, as the direction of the current and the magnetic flux in that area 803 are opposite to the current I₃ in the magnetic area 802, the resulting forces face in the same direction.

In accordance with the above, the fifth and the seventh spiral coils 615 and 617 show a direction of the current I₁ in positive x-direction in magnetic area 803 and in negative x-direction in the magnetic area 804. Therefore, the resulting electromagnetic force moves the PCB in a negative y-direction.

Furthermore, current I₂ flows in the sixth and eighth spiral coils 616, 618 counterclockwise, and thus in negative x-direction in the magnetic flux area 803 and in positive x-direction in flux area 804. This results in a overall force that is directed in positive y-direction.

Resulting from the above, the first, third, seventh and fifth spiral coils composing the focus circuit, consistently create an electromagnetic force that is directed in the negative y-direction. By changing the direction of the current I₁ the PCB is movable in the positive y-direction.

Referring now to the tilt circuit, the second 612 and fourth spiral coil 614 generate a force that is directed in negative y-direction, whereas the sixth and eighth spiral coil generate a magnetic force in the positive y-direction. Consequently, the board is rotated counterclockwise within the x-y-plane around an axis in z-direction, that is centered between the respective two coils of the tilt circuit on the left and right side of the PCB. Changing the direction of current I₂ reverses the rotating direction to a clockwise rotation of the PCB.

The tracking function is implemented through the ninth 619 and tenth coil 620, both generating a force in a positive x-direction. Again, by reversing the direction of current I₃ the force turns into the negative x-direction.

The different embodiments of the invention allow to provide a printed circuit board with printed coils thereon, that is more compact than in the prior art. The interleaving of the coils reduces the necessary layers from four layers to two layers, thus simplifying the structure of the PCB and consequently its production. Nevertheless, the strength of the generated electromagnetic force to move the PCB in the focus, tracking and tilt direction remains the same. The cost for constructing the PCB according to the invention is also decreased.

While the description is solely focused on the implementation of a printed circuit board along various patterns of conductive material fixed thereon in an optical pickup actuator, it is conceivable to consider other applications, such as electrical motors, electrical regulators or other similar applications, in which an electromagnetic force may be used, that results from current flowing in the PCB.

## Claims

1. A non-conductive actor substrate (601) with at least two spiral coils (611, 612) arranged thereon for generating a first magnetic field, which interacts with a second magnetic field for moving a mobile component (1),
**characterized in that**
a first spiral coil (611) and a second spiral coil (612) of conductive material are fixed on a first surface (602) of the non-conductive actor substrate and are interleaved with each other, and
wherein the first spiral coil and the second spiral coil are arranged around a first point on the first surface in such a way that, when a first and second current signal are introduced respectively into the first and second spiral coils, the mobile component moves in a direction substantially coplanar to the first surface of the non-conductive actor substrate.

2. The non-conductive actor substrate of claim 1, wherein the first and second spiral coils have substantially the same length.

3. The non-conductive actor substrate of claim 1, wherein the first and second spiral coils have a different length.

4. The non-conductive actor substrate of claims 1-3, wherein the mobile component is an objective lens of an optical pickup actuator for an optical data drive.

5. The non-conductive actor substrate of claims 1-4, wherein the mobile component is attached to the non-conductive actor substrate, and wherein the non-conductive actor substrate moves in a direction substantially coplanar to the first surface of the non-conductive actor substrate, when the first and second current signal are introduced respectively into the first and second spiral coils.

6. The non-conductive actor substrate of one of claims 1-5, wherein the first current signal is input via a first terminal (631), arranged on one edge of the first surface of the non-conductive actor substrate and connected to the first spiral coil, and wherein the first current signal flows from the first terminal via the first spiral coil to a second terminal (632), arranged on the other edge of the first surface of the non-conductive actor substrate.
wherein the second current signal is input via a third terminal (633), arranged on the one edge of the first surface of the non-conductive actor substrate and connected to the second spiral coil, and wherein the second current signal flows from the third terminal via the second spiral coil to a fourth terminal (634), arranged on the other edge of the first surface of the non-conductive actor substrate.

7. The non-conductive actor substrate of one of claims 1 to 6, further comprising a third spiral coil (613) and a fourth spiral coil (614) of conductive material fixed on a second surface (603) of the non-conductive actor substrate, wherein the second surface is the side opposite the first surface, wherein the third and fourth spiral coils are arranged around the first point, wherein the third and fourth spiral coils are interleaved with each other, wherein the third spiral coil is connected to the first spiral coil via a first connection (621) through the non-conductive actor substrate, and wherein the fourth spiral coil is connected to the second spiral coil via a second connection (622) through the non-conductive actor substrate.

8. The non-conductive actor substrate of claim 7, further comprising a fifth spiral coil (615) and a sixth spiral coil (616) fixed on the first surface of the non-conductive actor substrate, wherein the fifth spiral coil and the sixth spiral coil are arranged around a second point on the first surface, wherein the fifth and sixth spiral coils are interleaved with each other, and wherein the first point and second point are spaced at least a minimum distance from each other such that the first and second spiral coils do not overlap the fifth and sixth spiral coils.

9. The non-conductive actor substrate of claim 8, further comprising a seventh spiral coil (617) and an eighth spiral coil (618) fixed on the second surface of the non-conductive actor substrate, wherein the seventh spiral coil and the eighth spiral coil are arranged around the second point, wherein the seventh and eighth spiral coils are interleaved with each other, wherein the seventh spiral coil is connected to the fifth spiral coil via a third connection (623) through the non-conductive actor substrate, and wherein the eighth spiral coil is connected to the sixth spiral coil via a fourth connection (624) through the non-conductive actor substrate.

10. The non-conductive actor substrate of claim 9, wherein the eighth spiral coil is connected to the fourth terminal via a fifth connection (625) through the non-conductive actor substrate.

11. The non-conductive actor substrate of claims 9, wherein the third spiral coil is connected to the seventh spiral coil via a first pathway of conductive material arranged on the second surface of the non-conductive actor substrate, and wherein the fourth spiral coil is connected to the sixth spiral coil via a second pathway of conductive material arranged on the first or second surface of the non-conductive actor substrate and via a sixth connection(626) through the non-conductive actor substrate.

12. The non-conductive actor substrate of claim 11, wherein a first axis passes through the first point and the second point and a third point lies on the first axis between the first and second point, wherein a second axis passes through the third point and is perpendicular to the first axis and within the plane of the first surface, and when the first current signal flows through the first, third, seventh and fifth spiral coils, the mobile component moves in a focus direction, which is substantially coplanar to the first surface and in a direction substantially parallel to the second axis.

13. The non-conductive actor substrate of claim 11, wherein when the second current signal flows through the second, fourth, sixth and eighth spiral coils, the mobile component rotates in a tilt rotational direction, which is around a third axis, that is substantially perpendicular to the first and second axis.

14. The non-conductive actor substrate of claims 12 or 13, further comprising a ninth spiral coil (619) fixed on the first surface and arranged around the third point, in such a way that when a third current signal is introduced into the ninth spiral coil, the mobile component moves in a tracking direction, which is substantially within the plane of the first surface and in a direction substantially parallel to the first axis, and wherein the third point is spaced at least a minimum distance from the first point and the second point such that the ninth coil does not overlap the first, second, fifth and sixth coil.

15. The non-conductive actor substrate of claim 14, wherein the third current signal is input via a fifth terminal (635), arranged on the one edge of the first surface of the non-conductive actor substrate and connected to the ninth spiral coil, and wherein the third current signal flows from the fifth terminal via the ninth spiral coil to a sixth terminal (636), arranged on the other edge of the first surface of the non-conductive actor substrate.

16. The non-conductive actor substrate of claim 15, further comprising a tenth spiral coil (620) fixed on the second surface and arranged around the third point, and wherein the tenth spiral coil is connected to the ninth spiral coil via a seventh connection (627) through the non-conductive actor substrate.

17. The non-conductive actor substrate of claim 16, wherein the tenth spiral coil is connected to the sixth terminal via a third pathway on the first or second surface of the non-conductive actor substrate and via an eighth connection (628) through the non-conductive actor substrate.

18. A system comprising the non-conductive actor substrate according to any of claims 1 to 17, with at least two spiral coils arranged thereon for generating a first magnetic field, which interacts with a second magnetic field generated by a first magnet (6a) and a second magnet (6b), for moving a mobile component (1),
wherein the non-conductive actor substrate is placed between the first magnet and the second magnet,
and the first magnet and the second magnet are arranged such that poles of the first magnet face the opposite poles of the second magnet, and
wherein the mobile component is movable, when an electrical current flows through the at least two spiral coils.

19. The system of claim 18, wherein the mobile component is attached to the non-conductive actor substrate, and the non-conductive actor substrate is movable, when the electrical current flows through the at least two spiral coils.

20. The system of claim 18, wherein the mobile component is attached to one of the first or second magnet, and the one of the first or second magnet is movable when the electrical current flows through the at least two spiral coils.

21. A method for manufacturing a non-conductive actor substrate with at least two spiral coils arranged thereon for generating a first magnetic field, which interacts with a second magnetic field for moving a mobile component, said method comprising the following steps:
fixing a first spiral coil of conductive material on a first surface of the non-conductive actor substrate, wherein the first spiral coil is arranged around a first point on the first surface,
fixing a second spiral coil of conductive material on the first surface of the non-conductive actor substrate, wherein the second spiral coil is arranged around the first point and is interleaved with the first spiral coil, and
wherein the steps of fixing the spiral coils are such that when a first and second current signal are introduced respectively into the first and second spiral coil, the mobile component moves in a direction substantially coplanar to the first surface.

## Patentansprüche

1. Ein nichtleitender Aktorträger (601) mit wenigstens zwei Spiralspulen (611, 612), die darauf angeordnet sind, um ein erstes magnetisches Feld zu erzeugen, das mit einem zweiten magnetischen Feld interagiert, um ein bewegliches Element (1) zu bewegen,
**dadurch gekennzeichnet, dass**
eine erste Spiralspule (611) und eine zweite Spiralspule (612) aus leitendem Material auf einer ersten Oberfläche (602) des nichtleitenden Aktorträgers befestigt sind und in einander verschachtelt sind, und
wobei die erste Spiralspule und die zweite Spiralspule so um einen ersten Punkt auf der ersten Oberfläche angeordnet sind, dass, wenn ein erstes und zweites Stromsignal jeweils in die erste und zweite Spiralspulen eingebracht werden, das bewegliche Element sich in einer Richtung bewegt, die im Wesentlichen plan-parallel zu der ersten Oberfläche des nichtleitenden Aktorträgers ist.

2. Der nichtleitende Aktorträger aus Anspruch 1, wobei die ersten und zweiten Spiralspulen im Wesentlichen die gleiche Länge haben.

3. Der nichtleitende Aktorträger aus Anspruch 1, wobei die ersten und zweiten Spiralspulen unterschiedliche Längen haben.

4. Der nichtleitende Aktorträger aus den Ansprüchen 1-3, wobei das bewegliche Element eine Objektivlinse eines optischen Signalaufnehmeraktuators für ein optisches Datenlaufwerk ist.

5. Der nichtleitende Aktorträger aus den Ansprüchen 1-4, wobei das bewegliche Element mit dem nichtleitenden Aktorträger verbunden ist, wobei der nichtleitende Aktorträger sich in einer Richtung bewegt, die im Wesentlichen plan-parallel zu der ersten Oberfläche des nichtleitenden Aktorträgers ist, wenn das erste und zweite Stromsignal jeweils in die ersten und zweiten Spiralspulen eingebracht werden.

6. Der nichtleitende Aktorträger aus einem der Ansprüche 1-5, wobei das erste Stromsignal über eine erste Anschlussklemme (631) eingegeben wird, die an einer Kante der ersten Oberfläche des nichtleitenden Aktorträgers angeordnet ist und mit der ersten Spiralspule verbunden ist, und wobei das erste Stromsignal von der ersten Anschlussklemme über die erste Spiralspule zu einer zweiten Anschlussklemme (632) fließt, die an der anderen Kante der ersten Oberfläche des nichtleitenden Aktorträgers angeordnet ist,
wobei das zweite Stromsignal über eine dritte Anschlussklemme (633) eingegeben wird, die an der einen Kante der ersten Oberfläche des nichtleitenden Aktorträgers angeordnet ist und die mit der zweiten Spiralspule verbunden ist, und wobei das zweite Stromsignal von der dritten Anschlussklemme über die zweite Spiralspule zu einer vierten Anschlussklemme (634) fließt, die an der anderen Kante der ersten Oberfläche des nichtleitenden Aktorträgers angeordnet ist.

7. Der nichtleitende Aktorträger aus einem der Ansprüchen 1 bis 6, weiterhin umfassend eine dritte Spiralspule (613) und eine vierte Spiralspule (614) aus leitendem Material, das auf einer zweiten Oberfläche (603) des nichtleitenden Aktorträgers befestigt sind, wobei die zweite Oberfläche die gegenüberliegende Seite der ersten Oberfläche ist, wobei die dritten und vierten Spiralspulen um dem ersten Punkt angeordnet sind, wobei die dritten und vierten Spiralspulen ineinander verschachtelt sind, wobei die dritte Spiralspule mit der ersten Spiralspule über eine erste Verbindung (621) durch den nichtleitenden Aktorträger verbunden ist, und wobei die vierte Spiralspule mit der zweiten Spiralspule über eine zweite Verbindung (622) durch den nichtleitenden Aktorträger verbunden ist.

8. Der nichtleitende Aktorträger aus Anspruch 7, weiterhin umfassend eine fünfte Spiralspule (615) und eine sechste Spiralspule (616), die auf der ersten Oberfläche des nichtleitenden Aktorträgers befestigt sind, wobei die fünfte Spiralspule und die sechste Spiralspule um einen zweiten Punkt auf der ersten Oberfläche angeordnet sind, wobei die fünften und sechsten Spiralspulen ineinander verschachtelt sind, und wobei der erste Punkt und der zweite Punkt mindestens eine minimale Distanz voneinander beabstandet sind, so dass die ersten und zweiten Spiralspulen nicht mit den fünften und sechsten Spiralspulen überlappen.

9. Der nichtleitende Aktorträger aus Anspruch 8, weiterhin umfassend eine siebte Spiralspule (617) und eine achte Spiralspule (618), die auf der zweiten Oberfläche des nichtleitenden Aktorträgers befestigt sind, wobei die siebte Spiralspule und die achte Spiralspule um den zweiten Punkt angeordnet sind, wobei die siebten und achten Spiralspulen ineinander verschachtelt sind, wobei die siebte Spiralspule mit der fünften Spiralspule über eine dritte Verbindung (623) durch den nichtleitenden Aktorträger verbunden ist, und wobei die achte Spiralspule mit der sechsten Spiralspule über eine vierte Verbindung (624) durch den nichtleitenden Aktorträger verbunden ist.

10. Der nichtleitende Aktorträger aus Anspruch 9, wobei die achte Spiralspule mit der vierten Anschlussklemme über eine fünfte Verbindung (625) durch den nichtleitenden Aktorträger verbunden ist.

11. Der nichtleitende Aktorträger aus Anspruch 9, wobei die dritte Spiralspule mit der siebten Spiralspule über einen ersten Pfad aus leitendem Material verbunden ist, der auf der zweiten Oberfläche des nichtleitenden Aktorträgers angeordnet ist, und wobei die vierte Spiralspule mit der sechsten Spiralspule über einen zweiten Pfad aus leitendem Material, der auf der ersten oder zweiten Oberfläche des nichtleitenden Aktorträgers angeordnet ist und über eine sechste Verbindung (626) durch den nichtleitenden Aktorträger verbunden ist.

12. Der nichtleitende Aktorträger aus Anspruch 11, wobei eine erste Achse durch den ersten und den zweiten Punkt geht, und ein dritter Punkt auf der ersten Achse zwischen dem ersten und dem zweiten Punkt liegt, wobei eine zweite Achse durch den dritten Punkt geht und senkrecht zur ersten Achse ist und innerhalb der Ebene der ersten Oberfläche ist, und wenn das erste Stromsignal durch die ersten, dritten, siebten und fünften Spiralspulen fließt, das bewegliche Element sich in eine Fokusrichtung bewegt, die im Wesentlichen plan-parallel zu der ersten Oberfläche ist und in eine Richtung, die im Wesentlichen parallel zu der zweiten Achse ist.

13. Der nichtleitende Aktorträger aus Anspruch 11, wobei, wenn das zweite Stromsignal durch die zweiten, vierten, sechsten und achten Spiralspulen fließt, das bewegliche Element in einer Tilt-Rotationsrichtung rotiert, die um eine dritte Achse ist, die im Wesentlichen senkrecht zu den ersten und zweiten Achsen ist.

14. Der nichtleitende Aktorträger aus den Ansprüchen 12 oder 13, weiterhin umfassend eine neunte Spiralspule (619), die auf der ersten Oberfläche befestigt ist und die um einen dritten Punkt angeordnet ist, auf solch eine Weise, dass, wenn ein drittes Stromsignal in die neunte Spiralspule eingegeben wird, das bewegliche Element sich in eine Tracking-Richtung bewegt, die im Wesentlichen innerhalb der Ebene der ersten Oberfläche ist und in einer Richtung, die im Wesentlichen parallel zu der ersten Achse ist, und wobei der dritte Punkt mindestens eine minimale Distanz von dem ersten und dem zweiten Punkt beabstandet ist, so dass die neunte Spule nicht die erste, zweite, fünfte und sechste Spule überlappt.

15. Der nichtleitende Aktorträger aus Anspruch 14, wobei das dritte Stromsignal über eine fünfte Anschlussklemme (635) eingegeben wird, die an der ersten Kante der ersten Oberfläche des nichtleitenden Aktorträgers angeordnet ist und die mit der neunten Spiralspule verbunden ist, und wobei das dritte Stromsignal von der fünften Anschlussklemme über die neunte Spiralspule zu einer sechsten Anschlussklemme (636) fließt, die an der anderen Kante der ersten Oberfläche des nichtleitenden Aktorträgers angeordnet ist.

16. Der nichtleitende Aktorträger aus Anspruch 15, weiter umfassend eine zehnte Spiralspule (620), die auf der ersten Oberfläche befestigt ist und die um den dritten Punkt angeordnet ist, und wobei die zehnte Spiralspule mit der neunten Spiralspule über eine siebte Verbindung (627) durch den nichtleitenden Aktorträger verbunden ist.

17. Der nichtleitende Aktorträger aus Anspruch 16, wobei die zehnte Spiralspule mit der sechsten Anschlussklemme über einen dritten Pfad auf der ersten und zweiten Oberfläche des nichtleitenden Aktorträgers und über eine achte Verbindung (628) durch den nichtleitenden Aktorträger verbunden ist.

18. Ein System, das den nichtleitenden Aktorträger gemäß einem der Ansprüche 1 bis 17 umfasst, mit wenigstens zwei Spiralspulen, die darauf angeordnet sind, um ein erstes Magnetfeld zu erzeugen, das mit einem zweiten Magnetfeld, das durch einen ersten Magneten (6a) und einen zweiten Magneten (6b) erzeugt wird, interagiert, um ein bewegliches Element (1) zu bewegen,
wobei der nichtleitende Aktorträger zwischen dem ersten und zweiten Magnet platziert wird,
und der erste Magnet und der zweite Magnet so angeordnet sind, dass Polen des ersten Magneten die entgegengesetzten Pole des zweiten Magneten gegenüberstehen, und
wobei das bewegliche Element beweglich ist, wenn der elektrische Strom durch die wenigstens zwei Spiralspulen fließt.

19. Das System nach Anspruch 18, wobei das bewegliche Element an den nichtleitenden Aktorträger befestigt ist, und der nichtleitende Aktorträger beweglich ist, wenn der elektrische Strom durch die wenigstens zwei Spiralspulen fließt.

20. Das System aus Anspruch 18, wobei das bewegliche Element an einem der ersten oder zweiten Magnete befestigt ist, und eines der ersten oder zweiten Magnete beweglich ist, wenn der elektrische Strom durch die wenigstens zwei Spiralspulen fließt.

21. Ein Verfahren zum Herstellen eines nichtleitenden Aktorträgers mit wenigstens zwei Spiralspulen, die darauf angeordnet sind, um ein erstes Magnetfeld zu erzeugen, das mit einem zweiten Magnetfeld interagiert, um ein bewegliches Element zu bewegen, wobei das Verfahren die folgenden Schritte umfasst:
Befestigen einer ersten Spiralspule aus leitendem Material auf einer ersten Oberfläche des nichtleitenden Aktorträgers, wobei die erste Spiralspule um einen ersten Punkt auf der ersten Oberfläche angeordnet ist,
Befestigen einer zweiten Spiralspule aus leitendem Material auf der ersten Oberfläche des nichtleitenden Aktorträgers, wobei die zweite Spiralspule um den ersten Punkt angeordnet ist und mit der ersten Spiralspule ineinander verschachtelt ist, und
wobei die Schritte des Befestigens der Spiralspulen so sind, dass, wenn ein erstes und ein zweites Stromsignal jeweils in die erste und zweite Spiralspule eingegeben werden, das bewegliche Element sich in einer Richtung, die im Wesentlichen plan-parallel zu der ersten Oberfläche ist, bewegt.

## Revendications

1. Substrat actif non-conducteur (601) sur lequel sont agencées au moins deux bobines hélicoïdales (611, 612) pour générer un premier champ magnétique qui interagit avec un second champ magnétique de manière à déplacer un composant mobile (1),
**caractérisé**
**en ce qu'**une première bobine hélicoïdale (611) et une deuxième bobine hélicoïdale (612) en matériau conducteur sont fixées sur une première surface (602) du substrat actif non-conducteur et sont entrelacées, et
dans lequel la première bobine hélicoïdale et la deuxième bobine hélicoïdale sont agencées autour d'un premier point de la première surface de telle manière que, lorsqu'un premier et un deuxième signal de courant sont envoyés respectivement dans la première et la deuxième bobine hélicoïdale, le composant mobile se déplace selon une direction sensiblement coplanaire avec la première surface du substrat actif non-conducteur.

2. Substrat actif non-conducteur selon la revendication 1, dans lequel la première et la deuxième bobine hélicoïdale sont sensiblement de même longueur.

3. Substrat actif non-conducteur selon la revendication 1, dans lequel la première et la deuxième bobine hélicoïdale sont de longueur sensiblement différente.

4. Substrat actif non-conducteur selon l'une des revendications 1 à 3, dans lequel le composant mobile est une lentille d'objectif d'un actuateur de capture optique pour un support de données optiques.

5. Substrat actif non-conducteur selon l'une des revendications 1 à 4, dans lequel le composant mobile est fixé au substrat actif non-conducteur et dans lequel le substrat actif non-conducteur se déplace selon une direction sensiblement coplanaire avec la première surface du substrat actif non-conducteur lorsque le premier et le deuxième signal de courant sont envoyés respectivement dans la première et la deuxième bobine hélicoïdale.

6. Substrat actif non-conducteur selon l'une des revendications 1 à 5, dans lequel le premier signal de courant est envoyé via une première borne (631), agencée sur un bord de la première surface du substrat actif non-conducteur et connectée à la première bobine hélicoïdale, et dans lequel le premier signal de courant passe de la première borne via la première bobine hélicoïdale à une deuxième borne (632), agencée sur l'autre bord de la première surface du substrat actif non-conducteur,
dans lequel le deuxième signal de courant est envoyé via une troisième borne (633), agencée sur ledit bord de la première surface du substrat actif non-conducteur et connectée à la deuxième bobine hélicoïdale, et dans lequel le deuxième signal de courant passe de la troisième borne via la deuxième bobine hélicoïdale à une quatrième borne (634), agencée sur l'autre bord de la première surface du substrat actif non-conducteur.

7. Substrat actif non-conducteur selon l'une des revendications 1 à 6, comprenant en outre une troisième bobine hélicoïdale (613) et une quatrième bobine hélicoïdale (614) en matériau conducteur fixées à une seconde surface (603) du substrat actif non-conducteur, dans lequel la seconde surface est la face opposée à la première surface, dans lequel la troisième et la quatrième bobine hélicoïdale sont agencées autour du premier point, dans lequel la troisième et la quatrième bobine hélicoïdale sont entrelacées, dans lequel la troisième bobine hélicoïdale est connectée à la première bobine hélicoïdale via une première connexion (621) à travers le substrat actif non-conducteur et dans lequel la quatrième bobine hélicoïdale est connectée à la deuxième bobine hélicoïdale via une seconde connexion (622) à travers le substrat actif non-conducteur.

8. Substrat actif non-conducteur selon la revendication 7, comprenant en outre une cinquième bobine hélicoïdale (615) et une sixième bobine hélicoïdale (616) fixées à la première surface du substrat actif non-conducteur, dans lequel la cinquième bobine hélicoïdale et la sixième bobine hélicoïdale sont agencées autour d'un deuxième point de la première surface, dans lequel la cinquième et la sixième bobine hélicoïdale sont entrelacées, et dans lequel le premier point et le deuxième point sont espacés d'au moins une distance minimale de telle manière que la première et la deuxième bobine hélicoïdale ne chevauchent pas la cinquième et la sixième bobine hélicoïdale.

9. Substrat actif non-conducteur selon la revendication 8, comprenant en outre une septième bobine hélicoïdale (617) et une huitième bobine hélicoïdale (618) fixées à la seconde surface du substrat actif non-conducteur, dans lequel la septième bobine hélicoïdale et la huitième bobine hélicoïdale sont agencées autour d'un deuxième point, dans lequel la septième et la huitième bobine hélicoïdale sont entrelacées, dans lequel la septième bobine hélicoïdale est connectée à la cinquième bobine hélicoïdale via une troisième connexion (623) à travers le substrat actif non-conducteur, et dans lequel la huitième bobine hélicoïdale est connectée à la sixième bobine hélicoïdale via une quatrième connexion (624) à travers le substrat actif non-conducteur.

10. Substrat actif non-conducteur selon la revendication 9, dans lequel la huitième bobine hélicoïdale est connectée à la quatrième borne via une cinquième connexion (625) à travers le substrat actif non-conducteur.

11. Substrat actif non-conducteur selon la revendication 9, dans lequel la troisième bobine hélicoïdale est connectée à la septième bobine hélicoïdale via un premier chemin de matériau conducteur agencé sur la seconde surface du substrat actif non-conducteur, et dans lequel la quatrième bobine hélicoïdale est connectée à la sixième bobine hélicoïdale via un deuxième chemin de matériau conducteur agencé sur la première ou la seconde surface du substrat actif non-conducteur et via une sixième connexion (626) à travers le substrat actif non-conducteur.

12. Substrat actif non-conducteur selon la revendication 11, dans lequel un premier axe passe par le premier point et le deuxième point, et un troisième point se trouve sur le premier axe entre le premier et le deuxième point, dans lequel un deuxième axe passe par le troisième point et est perpendiculaire au premier axe et coplanaire avec la première surface, et lorsque le premier signal de courant passe par la première, la troisième, la septième et la cinquième bobine hélicoïdale, le composant mobile se déplace dans une direction de focalisation sensiblement coplanaire avec la première surface et dans une direction sensiblement parallèle au deuxième axe.

13. Substrat actif non-conducteur selon la revendication 11, dans lequel, lorsque le deuxième signal de courant passe par la deuxième, la quatrième, la sixième et la huitième bobine hélicoïdale, le composant mobile tourne selon une direction de rotation inclinée autour d'un troisième axe, qui est sensiblement perpendiculaire au premier et au deuxième axe.

14. Substrat actif non-conducteur selon l'une des revendications 12 ou 13, comprenant en outre une neuvième bobine hélicoïdale (619) fixée à la première surface et agencée autour du troisième point, de telle manière que quand un troisième signal de courant est envoyé dans la neuvième bobine hélicoïdale, le composant mobile se déplace dans une direction de poursuite, qui est sensiblement coplanaire avec la première surface et dans une direction sensiblement parallèle au premier axe, et dans lequel le troisième point est espacé d'au moins une distance minimale du premier point et du deuxième point, de telle manière que la neuvième bobine ne chevauche pas la première, la deuxième, la cinquième et la sixième bobine.

15. Substrat actif non-conducteur selon la revendication 14, dans lequel le troisième signal de courant est envoyé via une cinquième borne (635), agencée sur ledit bord de la première surface du substrat actif non-conducteur et connectée à la neuvième bobine hélicoïdale, et dans lequel le troisième signal de courant passe de la cinquième borne via la neuvième bobine hélicoïdale à une sixième borne (636), agencée sur l' autre bord de la première surface du substrat actif non-conducteur.

16. Substrat actif non-conducteur selon la revendication 15, comprenant en outre une dixième bobine hélicoïdale (620) fixée à la seconde surface et agencée autour du troisième point, et dans lequel la dixième bobine hélicoïdale est connectée à la neuvième bobine hélicoïdale via une septième connexion (627) à travers le substrat actif non-conducteur.

17. Substrat actif non-conducteur selon la revendication 16, dans lequel la dixième bobine hélicoïdale est connectée à la sixième borne via un troisième chemin sur la première ou la seconde surface du substrat actif non-conducteur et via une huitième connexion (628) à travers le substrat actif non-conducteur.

18. Système comprenant le substrat actif non-conducteur selon l'une quelconque des revendications 1 à 17, sur lequel sont agencées au moins deux bobines hélicoïdales pour générer un premier champ magnétique qui interagit avec un second champ magnétique généré par un premier aimant (6a) et un second aimant (6b) pour déplacer un composant mobile (1),
dans lequel le substrat actif non-conducteur est placé entre le premier aimant et le second aimant,
et le premier aimant et le second aimant sont agencés de telle manière que les pôles du premier aimant font face aux pôles opposés du second aimant, et
dans lequel le composant mobile peut être déplacé lorsqu'un courant électrique passe par lesdites au moins deux bobines hélicoïdales.

19. Système selon la revendication 18, dans lequel le composant mobile est fixé au substrat actif non-conducteur et le substrat actif non-conducteur est mobile lorsque le courant électrique passe par les au moins deux bobines hélicoïdales.

20. Système selon la revendication 18, dans lequel le composant mobile est fixé soit au premier, soit au second aimant, et ledit premier ou second aimant est mobile lorsque le courant électrique passe par les au moins deux bobines hélicoïdales.

21. Procédé de fabrication d'un substrat actif non-conducteur sur lequel sont agencées au moins deux bobines hélicoïdales, pour générer un premier champ magnétique qui interagit avec un second champ magnétique afin de déplacer un composant mobile, ledit procédé comprenant les étapes suivantes :
fixation d'une première bobine hélicoïdale en matériau conducteur sur une première surface d'un substrat actif non-conducteur, dans lequel la première bobine hélicoïdale est agencée autour d'un premier point sur la première surface,
fixation d'une deuxième bobine hélicoïdale en matériau conducteur sur la première surface du substrat actif non-conducteur, dans lequel la deuxième bobine hélicoïdale est agencée autour du premier point et est entrelacée avec la première bobine hélicoïdale, et
dans lequel les étapes de fixation des bobines hélicoïdales sont telles que lorsqu'un premier et un deuxième signal de courant sont envoyés respectivement dans la première et la deuxième bobine hélicoïdale, le composant mobile se déplace dans une direction sensiblement coplanaire avec la première surface.
